(19) **Europäisches Patentamt / European Patent Office / Office européen des brevets**

(11) **EP 2 438 451 B1**

(12) **EUROPEAN PATENT SPECIFICATION**

(45) Date of publication and mention
of the grant of the patent:
**19.03.2014 Bulletin 2014/12**

(51) Int Cl.:
**G01R 27/28** *(2006.01)* **G01R 31/28** *(2006.01)*

(21) Application number: **10731776.0**

(22) Date of filing: **04.06.2010**

(86) International application number:
**PCT/GB2010/001124**

(87) International publication number:
**WO 2010/139968 (09.12.2010 Gazette 2010/49)**

(54) **HIGH FREQUENCY MEASUREMENT APPARATUS AND METHOD WITH LOAD PULL.**

HOCHFREQUENZMESSER UND VERFAHREN MIT LASTZUG

APPAREIL ET PROCÉDÉ DE MESURE HAUTE FRÉQUENCE À EXTRACTION DE CHARGE

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **05.06.2009 GB 0909745**

(43) Date of publication of application:
**11.04.2012 Bulletin 2012/15**

(73) Proprietor: **Mesuro Limited
Cardiff
CF24 0AB (GB)**

(72) Inventor: **BENEDIKT, Johannes
Cardiff CF10 5GT (GB)**

(74) Representative: **Williams, Rhys Nicholas et al
Abel & Imray
20 Red Lion Street
London WC1R 4PQ (GB)**

(56) References cited:
**WO-A1-2005/010538**

- **CAMARCHIA V ET AL: "Microwave Measurements Part II Non-linear Measurements" IEEE INSTRUMENTATION & MEASUREMENT MAGAZINE, IEEE SERVICE CENTER, PISCATAWAY, NJ, US, vol. 10, no. 3, 1 June 2007 (2007-06-01), pages 34-39, XP011189368 ISSN: 1094-6969**
- **MAURO MARCHETTI ET AL: "Active Harmonic Loadâ Pull With Realistic Wideband Communications Signals" IEEE TRANSACTIONS ON MICROWAVE THEORY AND TECHNIQUES, IEEE SERVICE CENTER, PISCATAWAY, NJ, US LNKD- DOI:10.1109/TMTT.2008.2007330, vol. 56, no. 12, 1 December 2008 (2008-12-01), pages 2979-2988, XP011238478 ISSN: 0018-9480**
- **FERRERO A ET AL: "Recent technological advances for modular active harmonic load-pull measurement systems" PROCEEDINGS OF THE EUROPEAN GALLIUM ARSENIDE AND RELATEDCOMPOUNDS APPLICATIONS SYMPOSIUM, XX, XX, 5 October 1999 (1999-10-05), page 5PP, XP002303785**

EP 2 438 451 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to a measurement apparatus for measuring the response of an electronic device to a high frequency input signal and a method of measuring the response of an electronic device to a high frequency signal. In particular, but not exclusively, the invention relates to a measurement system and method for analysing, and characterising, the behaviour of a high frequency device, commonly referred to in the art as a device under test (or DUT) at relatively high power levels. Such devices may for example need to be analysed when designing devices or designing circuits utilising such devices, for use in high power (large signal) high frequency amplifiers, such as an amplifier for use in a mobile telephone network or other telecommunications-related base-station. The invention also relates to a method of improving the performance of circuits including such a device.

When analysing the behaviour of a high frequency electronic device it is often desired to assess the behaviour of the device under the sort of conditions that the device might be subjected to during normal operation. For example, the impedance to which the device is attached during its normal/final operation may determine to a high degree the performance, for example the efficiency and/or linearity, of the device. Such considerations are for example of particular relevance when designing high frequency large signal amplifier circuits for use in for example a mobile telecommunications base station. It is therefore desirous to be able to analyse the device when subjected to a (possibly "virtual") load/impedance at the input and/or output of the device.

One means of applying such a virtual impedance is to apply an active load pull, wherein a signal with a given magnitude and phase relative to an input signal inputted into the device under test is injected into a port (for example the input or output) of the device under test.

Another means of applying such an impedance is to use an passive load pull device, with an adjustable impedance.

The present invention proposes the use of a hybrid system utilising both passive load pull and active load pull. Each load pull architecture has its advantages and disadvantages, but embodiments of the present invention provide unique architectures that utilise the advantages of one system to mitigate the disadvantages associated with the other. Those skilled in the art have traditionally viewed the two types of load pull as being independent of each other and whilst there may be proposals in the prior art relating to active load pull architectures in which a passive load pull device or component is present, for example as a pre-matching tuner, the embodiments of the present invention have several unique advantages as set out below. For example, embodiments of the present invention have the advantage of enabling multi-tonal load pull to be achieved by simultaneously using both passive and active load pull methodologies.

One embodiment of the invention relates to a measurement apparatus for measuring the response of an electronic device to a high frequency input signal, the measurement apparatus including, an active load-pull circuit connectable in use to an electronic device to be measured, and wherein the active load pull circuit includes a passive load-pull device characterised in that the passive load-pull device is configured to transform the characteristic impedance of the load pull circuitry such that lower power levels are required to be generated by the active load-pull circuit.

A control unit, for example a suitably programmed computer with associated interface circuitry, may be used to coordinate the settings of the passive load pull device and the active load pull circuit.

It will of course be appreciated that an apparatus according to the invention may be provided without the electronic device to be measured.

The active load-pull circuit may be an open load-pull circuit. For example, the active load pull circuit may be arranged to inject power into the electronic device to be tested without any feedback loops from the electronic device. Dedicated signal generators may be provided.

The active load-pull circuit may comprise a closed-loop load-pull circuit. For example, the active load-pull circuit may be in the form of an envelope load-pull circuit, that is, a closed-loop load-pull circuit with out-of-band filtering and/or in-band signal modification. Out-of-band filtering can be achieved by means of providing a filter within the feedback loop to remove frequency components outside the frequency range of interest. In-band signal modification may be achieved by, for example, digital signal processing within the feedback loop. Either out-of-band filtering or in-band signal modification may be performed in order to reduce signal oscillations. The band of frequencies may extend to cover signals around DC such as modulation, base band (BB), or intermediate frequencies (IF). The concept of envelope load pull is described and claimed in PCT patent application entitled "High Frequency Circuit Analyser" published under publication number WO 2005/010538. The contents of that application are fully incorporated herein by reference. The claims of the present application may incorporate any of the features disclosed in that patent application. In particular, the claims of the present application relating to envelope load pull may be amended to include features relating to (a) a feedback circuit being arranged to modify a signal from the electronic device (b) a feedback circuit being arranged to feed a (modified) signal back to the ' electronic device and/or (c) a feedback circuit being arranged to limit the magnitude gain of the feedback circuit at all frequencies within a frequency range of operation. For example, such features may include arranging for the phase change and/or the magnitude gain of the feedback circuit at one or more frequencies within the frequency range to be adjusted.

The active load-pull circuit may include a plurality of passive load-pull devices. The measurement apparatus may include a signal generating circuit arranged to generate a multi-component signal for applying to a device to be measured. The signal may for example comprise components at a fundamental frequency and at one or more harmonic frequencies. The multi-component signal may comprise a plurality of components at and around the fundamental frequency. The multi-component signal may comprise a plurality of components at and around one or more harmonic frequencies. The multi-component signal may for example comprise a DC component. The multi-component signal may for example comprise frequencies close to the DC component, such as for example modulation, base band (BB), or intermediate frequencies (IF). The multi-component signal may for example comprise a component having a frequency of greater than 1GHz (which may for example be the fundamental frequency). The multi-component signal may comprise a component having a frequency of between 0.1 kHz and 100MHz, that is, a signal emulating a modulation signal at a frequency lower than the RF fundamental frequency. The measurement apparatus may include a plurality of signal paths. Each signal path may be associated with a different component of the multi-component signal. Of course, in the case where the multi-component signal comprises multiple components at the fundamental frequency and at the one or more harmonic frequencies, each signal path may be associated with a different *set* of components of the multi-component signal. There may for example be at least three signal paths, each associated with a different component (and optionally also different sets of multiple components) of the multi-component signal. The signal generating circuit is preferably able to produce high frequency signals of, for example, up to 50 GHz.

A passive load-pull device may be provided in one of the signal paths associated with a single component of a multi-component signal to be applied to the device. The apparatus may include a plurality of passive load-pull devices. Preferably, at least one passive load-pull device is associated with the signal path associated with the component at the fundamental frequency. The apparatus may include at least two passive load-pull devices arranged so that at least one passive load-pull device is associated with each of a plurality of connections arranged to connect to different ports of a device. There may be a passive load-pull device in two or more of the signal paths associated with different components of a multi-component signal to be applied to the device.

The measurement apparatus may include a multiplexer circuit. The multiplexer circuit may be arranged to combine different signal components to create a multi-component signal outputted on a further signal path, along which a passive load-pull device may optionally be provided. A multiplexer circuit may be arranged to split a multi-component signal into different signal components, which are modified in differing ways, to create a multi-tonal active load pull effect. For example, the different signal components may be modified by means of an amplifier. One or more of the different signal components may be modified by means of a passive load-pull device. The apparatus may be arranged such that a passive load-pull device acts on all signal components of a multi-component signal to be applied to the device, for example by means of one passive load-pull device acting simultaneously on all signal components or by means of multiple passive load-pull devices each acting on a different signal component.

The measurement apparatus may be arranged to make measurements across a bandwidth of frequencies including a fundamental frequency and at least one harmonic frequency. The, or each, passive load-pull device provided as part of the active load-pull circuit may be arranged to function at a multiplicity of different, preferably all, frequencies across the bandwidth. The active load-pull circuit may be arranged to compensate for the variation in impedance of the passive load pull device at different frequencies. For example, the active load-pull circuit may be arranged to compensate for changes in the characteristic impedance of the load-pull circuit caused by adjustment of the passive load pull device. Using the passive load pull device to set a characteristic impedance of the load-pull circuit at a certain frequency can have undesired effects on the characteristic impedance of the load-pull circuit at other frequencies. The active load pull circuit may be used to compensate for these undesired effects. Also, the passive load pull device may be used to transform the characteristic impedance of the load-pull circuit to bring it closer to a desired impedance and the active load-pull circuit may be used to compensate for differences between the impedance actually set by the passive load-pull device and the desired, or target, impedance at a particular frequency. Such compensation by the active load-pull circuit may be conducted at multiple frequencies across the bandwidth of active load-pull circuit.

The measurement apparatus may include a plurality of active load-pull circuits. Each active load-pull circuit may be arranged to be connectable in use to a different port of a multi-port device. Each active load-pull circuit may include a passive load-pull device. Each active load-pull circuit may be configured so as to have the features described herein. The active load-pull circuits may be configured differently to each other. Two or more active load-pull circuits may be configured with identical topology to each other. For example, the topological arrangement of all of the one or more passive load pull devices within one active load-pull circuit may be different from the topological arrangement of all of the one or more passive load pull devices of another active load-pull circuit.

Preferably, the apparatus is configured such that measurements are taken from a port of the device. The apparatus may for example include an RF coupler for connection to a waveform measuring device, such as for example an oscilloscope or vector network analyser, the RF coupler being provided directly adjacent to the region at which the device is to be coupled to the measurement apparatus.

Another embodiment of the invention relates to a method of measuring the response of an electronic device under test to a high frequency input signal including simultaneously utilising both an active load pull circuit and a passive tuner component. The measurement apparatus may be in accordance with the measurement apparatus of the invention as described herein.

The method of measuring the response of the DUT may include a step of providing a DUT having two or more ports. The method may include a step of providing a microwave frequency signal sampling apparatus connected to take measurements from at least one port of a DUT, preferably directly from the DUT port (preferably connecting as topologically close to the port as practically possible). The DUT may be directly connected to an RF coupler and the RF coupler may be connected to a waveform analyser (for example a VNA or oscilloscope) to enable measurement by the waveform analyser of RF signals at the port(s) of the DUT.

The method includes a step of using an active load pull circuit to apply an active load at at least one port of the DUT. The active load may be such that the sum power of the signals of the active load applied is greater than 10 Watts (rms).

The active load applied may include a signal having a low-frequency or DC component. The active load applied may include a high-frequency component at a fundamental frequency, and optionally high-frequency components at one or more harmonic frequencies. The frequency of the high-frequency component at the fundamental frequency may be greater than 1 GHz. The active load may be provided via one or more signal paths, each signal path being dedicated to a signal component of a different frequency. The method includes providing a passive tuner component. A passive tuner component may be provided in one of said one or more signal paths. A passive tuner component may be provided in each of two or more of the signal paths. The method may include a step of controlling, preferably simultaneously, the load applied to the device at the fundamental frequency and at a harmonic frequency. The method may include a step of setting the reflection coefficient at the fundamental frequency, for example by using at least one such passive tuner component. The passive tuner component(s) may be used to change the characteristic impedance of the active load circuit at at least the fundamental frequency. This may have the beneficial effect of reducing the electric power of the signals required to be generated by the active load pull circuit.

The method may include performing measurements, on the same device under test, in which the fundamental frequency is at a first frequency and then performing measurements in which the fundamental frequency is at a second frequency, different from the first frequency. The same active load pull circuit may be used. The same passive tuner component may be used. The method may include performing a systematic frequency scan, for example varying the fundamental frequency across a range of different frequencies. The range of different frequencies may span from the lowest to the highest possible fundamental frequencies of operation, in practice, of the DUT. The range of different frequencies may alternatively span across a range of frequencies merely covering a fundamental frequency and typical mixing frequency components (i.e. close to the fundamental frequency).

The method may include a step of setting at least one passive tuner component in a first state in connection with measurements made with the fundamental frequency at a first frequency, and then keeping said at least one such passive tuner component set in said first state whilst making measurements with the fundamental frequency at a second frequency, different from the first frequency. An active load-pull circuit may be used to compensate for the variation in impedance of the passive load pull device at different frequencies, for example to compensate for the change of the impedance of the passive tuner at the first frequency to the impedance of the passive tuner at the second frequency. For example, the active load-pull circuit may be used to compensate for changes in the characteristic impedance of the load-pull circuit caused by adjustment of the passive load pull device, as described above in relation to the measurement apparatus of the invention.

The present invention further provides a method of improving the design of a high frequency high power device or a circuit including a high frequency high power device, the method including the steps of analysing the behaviour of the device either by using the measurement apparatus according to the present invention or by performing the method according to the present invention, and then modifying the design of the device or modifying the circuit including the device in consideration of the results of the analysing of the behaviour of the device.

The present invention yet further provides a method of manufacturing a high frequency high power device or a circuit including a high frequency high power device. The method may include a step of using a measurement apparatus to measure the response of the device to a high frequency input signal, for example to characterise the device. Such measurements may be used to create or improve the design of a similar existing device or of an existing circuit including such a device. Thus, the method of manufacturing the device may include a step of performing the method described immediately above. The device or the circuit including the device in accordance with the design so created or improved may then be made.

The present invention also provides a method of testing one or more high frequency high power devices, by characterising the behaviour of the, or each, device either by using the measurement apparatus according to the present invention or by performing the method according to the present invention. The testing method may be used during manufacture of devices, for example in quality control. The testing method may be used in a method of "screening" devices. The testing method may include a step of rejecting a device as having characteristics not meeting preset criteria. The testing method may include a step of allocating each device to a group of devices, each group sharing similar response characteristics. Thus, the group to which a device is allocated is determined according to the results of the measurements made during performance of the step of characterising the behaviour of the device. Each group may for example be defined by mutually exclusive preset criteria. Thus, the testing method may be used in a method of "binning" devices.

It will of course be appreciated that features described in relation to one aspect of the present invention may be incorporated into other aspects of the present invention. For example, the method of the invention may incorporate any of the features described with reference to the apparatus of the invention and *vice versa.*

Description of the Drawings

Embodiments of the present invention will now be described by way of example only with reference to the accompanying schematic drawings of which:

Figure 1      shows a schematic circuit diagram according to a first embodiment of the invention;

Figure 2      shows a schematic circuit diagram illustrating a device under test attached to a load;

Figure 3      shows a schematic circuit diagram according to a second embodiment of the invention;

Figure 4      shows a schematic circuit diagram according to a third embodiment of the invention;

Figure 5      shows a schematic circuit diagram according to a fourth embodiment of the invention;

Figure 6      shows a schematic circuit diagram according to a fifth embodiment of the invention; and

Figure 7      shows a schematic circuit diagram according to a sixth embodiment of the invention.

Detailed Description

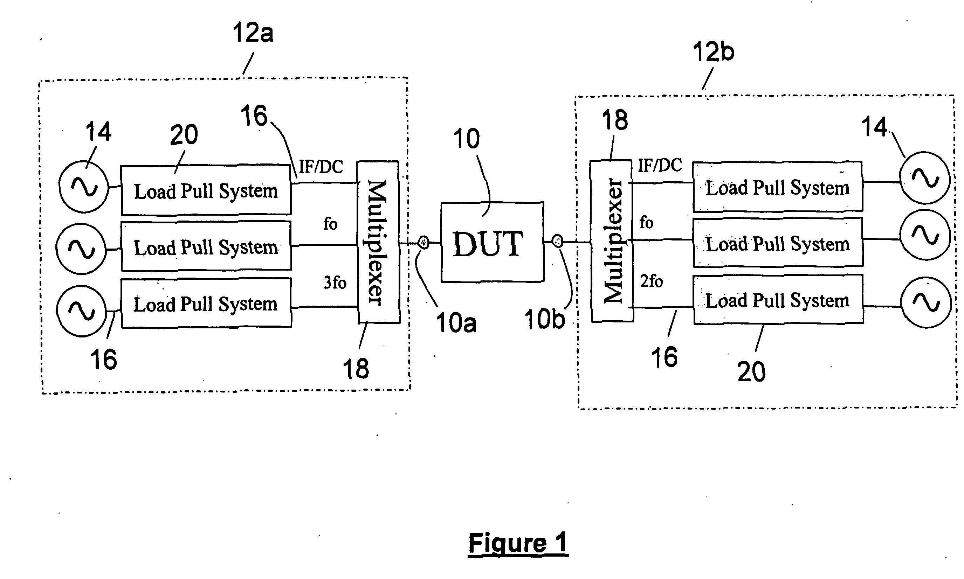

Figure 1 shows a first embodiment of the present invention comprising an active load pull circuit incorporating a plurality of passive load-pull devices. Before describing the layout and operation of the embodiment illustrated in Figure 1, a brief description of passive load pull architectures and active load pull architectures will be provided.

In general, a device under test (DUT) can be assumed as either a current or voltage source. In the first instance the device is assumed to generate a current waveform that consists of single or multiple frequency components within the fundamental frequency band and harmonically related frequency bands such as DC, 2nd, 3rd, 4th,..., nth harmonic frequency. The same is the case when the DUT is a voltage source.

When measuring the characteristics of a DUT, a signal is typically applied, to an input port for example, whilst a load is applied, to an output port for example. The purpose of the load is to take the current (or voltage waveform) and transform it into a desirable voltage (or current) waveform; application of Ohm's law. The impedance is typically chosen such that the device performance is optimal, e.g. giving high gain, efficiency, or output power. An impedance of about 50 Ohms is a standard choice.

Typically, it is not known *a priori* what impedance value at which frequency component constitutes the optimum. As a result the user is forced to conduct multidimensional scans. To facilitate such scans 'load pull systems' have been developed that allow to load the DUT with different impedance values $Z_L$.

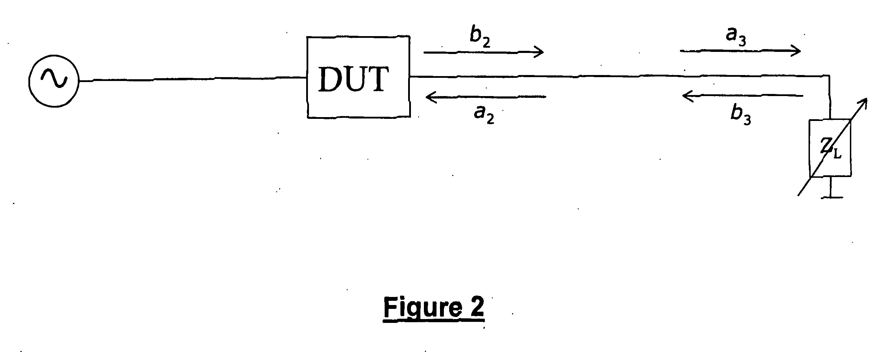

The effect of the load impedance $Z_L$ can be described mathematically using waveforms that are travelling along a connection. Consider, for example, a DUT connected to a test signal at an input port and to a variable load $Z_L$ at an output port. Such an arrangement is shown in Figure 2. Typically, the waveform injected into the DUT output is called the forward travelling waveform $b_2$, while the signal $a_2$, which is being either generated by the DUT or represents a partial reflection of $b_2$, is referred to as the scattered waveform. Similarly, from the perspective of the load, $Z_L$, the forward waveform passed into the load may be called $b_3$, while the signal, reflected or generated by the load, may be called $a_3$. In the illustrated schematic diagram of Figure 1, and assuming no in-line attenuation, $a_2 = b_3$ and $a_3 = b_2$.

The use of travelling waveforms is similar to what is readily experienced at optical frequencies with signals travelling towards a lens, which depending on the properties will partially transmit and partially reflect the signal.

Only a part of the energy that is generated by the DUT is dissipated at the load $Z_L$. This load impedance typically represents another system that reacts to and follows the output of the DUT so that the energy that is dissipated within the load represents the part that is useful power.

The power dissipated within the load is related to the difference between the two travelling waveforms:

$$P_L = \frac{1}{2} * \left( |a_3|^2 - |b_3|^2 \right)$$

The value of the load impedance is related to the portion of the signal $a_3$ that the load can reflect back, thereby contributing to the forward travelling waveform $b_3$. The direct ratio $\Gamma_L = b_3 / a_3$, is called the load reflection coefficient with $a_3$ always being larger than $b_3$, with the resulting coefficient $\Gamma_L$ always being smaller than unity. (If $b_3$ were larger than $a_3$ this would effectively represent more energy being reflected back from, than inserted in-

to, the load.) The reflection coefficient $\Gamma_{DUT}$ of the DUT is equal to $b_2 / a_2$ will in the arrangement shown in Figure 2 appear to be larger than unity.

High-power DUTs typically demand a low load impedance, resulting in a relatively high load reflection coefficient $\Gamma_L$, to dissipate the maximum power within the load. Thus, it is desirable to have a load reflection coefficient $\Gamma_L$ which is close to unity, whilst ensuring that $b_3$ is less than $a_3$.

At the same time, in a high-power DUT it is important to deliver a significant amount of power into $Z_L$ and we therefore require a large difference between $a_3$ and $b_3$.

To reconcile both conditions the power contained within $a_3$ ($\sim|a_3|^2$) and $b_3$ ($\sim|b_3|^2$) must be much larger than the power $P_L$ dissipated within the load.

For instance assuming ½ $|a_2|^2$=1000W and ½$|b2|^2$=900W would result in $P_L$=1000W-900W=100W for a reflection coefficient, (where $|\Gamma_L|^2$ = 900/1000, so that $|\Gamma_L| \sim 0.95$) that can be considered relatively high, without being greater than 1. The load pull required to adequately test high power DUTs (for example, using 100W DUTs) might therefore require the use of travelling waveforms having powers much greater than 100W. The resulting power levels might be too large for the measurement system to handle and/or may result in arcing or overheating of components.

To combat such problems, whilst generating the travelling waveform $b_3$ with sufficient electric power, specialist high power circuitry may be required with the consequential disadvantage of increased complexity and greater expense.

To achieve a high load reflection coefficient, the travelling waveform $b_3$ has to be as large or nearly as large as the signal $a_3$ (equal to, or at least closely related to, the signal $b_2$ which in use would be primarily generated by the DUT). Any loss between $Z_L$ and the DUT will attenuate the signal $b_3$, which in the test set is primarily dependent on the load, and therefore reduce the range of $\Gamma_L$ values that can be set by changing the load impedance.

It is important to note that the concept of travelling waveforms $a_2$ and $b_2$, and $a_3$ and $b_3$, is a mathematical concept to describe the effects of currents and voltages, which exist within the DUT and load impedances. Thus, each travelling waveform is represented by a complex number, representing amplitude and phase. The effect of a medium and/or transmission line/ waveguide through which the travelling waveforms are transmitted can be expressed by means of a matrix transformation (using S-parameters, for example) of the travelling waveforms at either side of an interface. The current and voltage waveforms are absolute and can be directly traced to SI units, while the concept of travelling waveforms are ratioed in respect to the medium through which the signals are travelling. Using the optical analogy, the amount of the reflection that is generated at a surface or interface will depend on the physical properties (here refraction index n) of the materials forming the surface.

Therefore, the reflection coefficient $\Gamma_L$ will depend on the environment through which the waves $a_3$ and $b_3$ are travelling. This environment is referred as the 'characteristic impedance $Z_0$', and is typically assumed to be 50 Ohms. By varying the characteristic impedance $Z_0$, and therefore controlling changes with frequency of the load reflection coefficient $\Gamma_L$, the requisite levels of currents and voltages can still be achieved, thereby reducing the required power of the $b_2$ travelling wave and therefore making its generation more feasible and cost-effective.

Varying the characteristic impedance of a load when analyzing the performance of a high power high frequency DUT has traditionally been achieved by means of a passive load-pull circuit or an active load pull circuit. Each system has its advantages and disadvantages.

A passive load pull circuit typically includes a tuner as a passive structure (typically a coaxial line) that can be mechanically changed in size, therefore changing its electrical properties. The changes may for example be introduced by a "slug" inside the coaxial line that can be traversed with the help of stepper motors. The slug allows precise setting of the impedance of the passive tuner, but only at one frequency, because the characteristics of the passive tuner will of course depend on the signal frequency. Changing the setting of the passive tuner at a fundamental frequency of interest will introduce changes at other frequencies in the range of interest. If the measurements of the DUT are to be performed at multiple frequencies, then the use of a single passive tuner will be inadequate because the impedance of the tuner will have the desired value at one frequency, but possibly undesired values at all other frequencies. In order to deal with this issue, either multiple passive tuners or multiple slugs are required to enable control of the impedance at a number of different frequencies. The resulting set-up procedure then becomes complex and expensive.

Furthermore, passive tuner structures (typically simply coaxial lines) are often lossy structures and therefore cause significant attenuation of the travelling wave $b_2$, therefore restricting the range of reflection coefficients $\Gamma_L$ that can be set. This can mean that it is not possible to test the response of the DUT at certain values of $\Gamma_L$, necessary to provide full characterization of the DUT.

Also, the change in phase of the signal effected by the passive tuner needs to be controlled. When using a length of coaxial line, the length of the coaxial line may need to be prohibitively long at lower frequencies of interest (at frequencies for example of less than 100MHz).

Many of the drawbacks of a passive load-pull system can be mitigated or avoided by means of using an active load-pull system, in which active elements generate signals that contribute to defining the travelling waveform $b_3$. It is important to note however that the active system cannot vary the characteristic impedance $Z_0$

through which the travelling waveforms are transmitted as neither the medium nor the geometry of the transmission line/waveguide is altered, hence setting a reflection coefficient is achieved by varying the power of the travelling waveform $b_3$.

In comparison to the passive load pull system, an active load pull circuit can generate a waveform $b_3$ at one frequency, which does not influence the reflection coefficient at any other frequency. Also, signal generators can actively generate a signal at any frequency (from DC to 100s of GHz), without phase change problems as the structure between the signal generator and the DUT is physically unchanged. However, the generation of high reflection coefficients can require prohibitive power levels within signal $b_3$.

In contrast to the solely passive load pull system and the solely active load pull system described above, the embodiment illustrated in Figure 1 has both passive load pull elements and active load pull elements. This hybrid system mitigates the problems described above.

Figure 1 shows a DUT 10 having an input port 10a and an output port 10b. A first active load pull circuit 12a is connected to the input port 10a and a second active load pull circuit 12b is connected to the output port 10b. Each active load pull circuit includes a plurality of signal generators 14, including a signal generator arranged to generate a high frequency signal $f_0$ at a fundamental frequency, a signal generator arranged to generate a high frequency signal $2f_0$, $3f_0$, or $nf_0$ at a harmonic frequency and signal generator arranged to produce a relatively low frequency signal DC/IF (DC to intermediate frequencies - i.e. significantly lower than the fundamental frequency $f_0$). In Figure 1, the input port active load pull circuit 12a is shown as injecting at the input port 10a a signal having DC/IF, $f_0$, and $3f_0$ components , whereas the output port active load pull circuit 12b is shown as injecting at the output port 10b a signal having DC/IF, $f_0$, and $2f_0$ components.

In this embodiment, each active load pull circuit has three signal paths 16, one associated with each signal generator 14. The signal paths are combined into one by means of a multiplexer circuit 18, which combines the three signal components into the multi-component composite signal that is applied at the appropriate port of the DUT. In each of the three separate signal paths 16 of each active load pull circuit 12 there is provided a passive load pull device 20, in the form of a passive tuner component (for example a coaxial line with a movable slug to provide variable tuning).

Each passive tuner component 20 is, in use, used to influence the characteristic impedance of the active load pull circuit such that lower power levels within the forward travelling waveform $b_3$ are required, thus making the generation of the signal $b_3$ feasible and affordable for the desired reflection coefficient values and frequencies, over the entire bandwidth of frequencies of interest. Whilst each passive tuner can be used to alter the characteristic impedance of the active load pull circuit in a controlled manner at the frequency of interest, the impedance at other frequencies is also affected. However, such effects can be compensated for by means of the active sources. This compensation works over the entire bandwidth over which the active signal source can operate.

The system illustrated in Figure 2 can emulate circuits that the DUT might be embedded into at a later design stage over a wide range of frequencies including DC/IF, $f_0$, $2f_0$, $3f_0$, ... $nf_0$, etc. This emulation is not limited to multiples of a single fundamental frequency, but can also be achieved over a bandwidth of different frequencies within the frequency range of the active signal sources. The resulting system is therefore very flexible and can be used to emulate specific circuit architectures such as an 'envelope tracking amplifiers" or Doherty amplifiers, which require characterization across a wide range of powers, impedances, and frequencies.

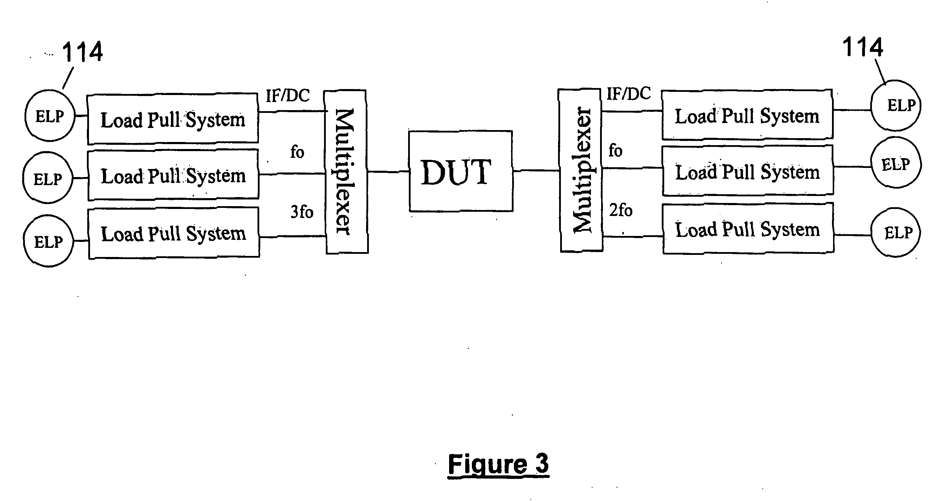

The embodiment shown in Figure 1 can be considered as an open load-pull architecture. Figure 3, shows a second embodiment of the invention using an envelope load-pull architecture, in which signals from the DUT are fed back through the active load pull circuit. WO 2005/010538 provides details on how such an architecture may be implemented. Such feedback allows better control and setting of the reflection coefficient. The feedback loop is omitted from Figure 3, for the sake of clarity, the envelope load-pull nature of the embodiment being represented by the letter ELP on the signal generators 114. The resulting system behaves more like a passive load than the Figure 1 system, as the envelope load pull circuit reacts to any signal changes coming from the DUT at different power levels, as a result of the feedback loop, thus reducing changes in the reflection coefficient that would otherwise occur at different power levels. Furthermore, out-of-band high-frequency signal oscillations are reduced by means of a suitable filter within the feedback loop. In-band signals may also be controlled by the envelope load pull circuit by means of suitable signal transforming/processing means within the feedback loop. The operation and other advantages of the circuit of Figure 3 are similar to those described above in relation to Figure 2.

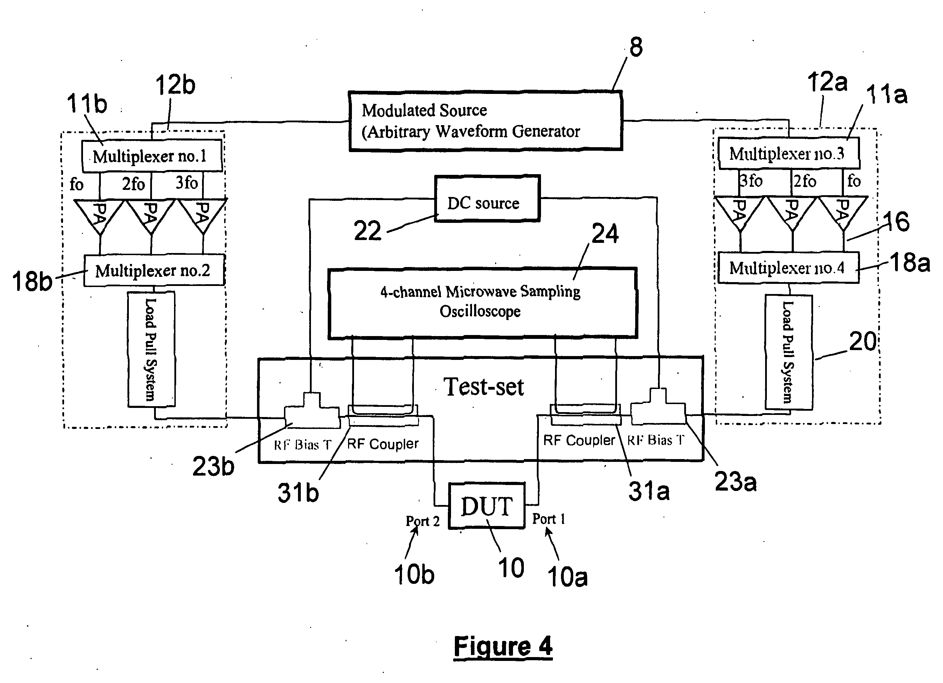

Figures 4 to 7 show implementations of a hybrid active and passive load pull system in measurement apparatus according to third to sixth embodiments of the invention. The third to sixth embodiments of the invention share certain features, which will now be described with reference to Figure 3.

Figure 4 is a schematic circuit diagram showing a high frequency non-linear measurement system according to a third embodiment of the present invention. The measurement system is based around a VNA (vector network analyser with integrated source). The VNA thus comprises a modulated source (arbitrary waveform generator) 8, DC source 22 and a microwave sampling oscilloscope 24. It will be appreciated that those three components can be provided in one product by means of commercially available vector network analysers.

The measurement system is arranged to measure characteristics of a two-port device under test (DUT) 10, having first and second ports, 10a, 10b. The modulated source 8 generates the RF signals in the GHz range including the fundamental frequency and harmonics. The composite signal from the source 8 is divided into separate component signals by means of multiplexers 11, one 11a arranged to feed a first side of the circuit and one 11b arranged to feed the second side of the circuit. The modulated source may also be arranged (not shown) to generate a frequency significantly lower than the fundamental frequency such as the base-band, intermediate frequencies (IF) or modulation frequencies, having a frequency in the MHz range. The separate component signals are the amplified by the desired, in all likelihood different, amounts by three parallel arranged dedicated amplifiers (labelled PA in the figures). The amplified composite signals on the separate signal paths 16 are recombined by further multiplexers 18, one for each side of the circuit, to produce a multi-component composite signal, which in this embodiment has three different high-frequency components at a fundamental frequency $f_0$ and two harmonic frequencies $2f_0$ and $3f_0$. The multi-component composite signal is combined with a DC current (provided by the DC source of the VNA) on each side by means of a respective bias T device 23a, 23b and then fed to a respective port of the DUT 10.

The DUT 16 is connected to a load pull circuit at each port 10a, 10b, each load pull circuit comprising both active load pull elements and passive load pull elements. The load pull circuit on each side of the DUT enables emulation of impedances at all operational frequencies. In this particular embodiment, the load pull circuits each emulate (load) impedance at three different frequencies simultaneously and, optionally, at a multitude of frequencies around each of the three different frequencies (fundamental, second, and third harmonics).

An oscilloscope 24 measures waveforms in the circuit at various RF frequencies by means of RF couplers 31a, 31b, connected to the oscilloscope 24.

The load pull circuit on each side of the DUT may be considered as an active load pull circuit comprising a passive load-pull device. Thus, on the "Port 1" side of the circuit, there is provided an active load pull circuit 12a comprising a passive load pull device 20a.

The circuits shown in Figures 4 to 7 show different architectures, each of which may be suited for use in certain applications. The differences between the carious architectures will now be described.

In Figure 4, the passive load pull device 12 of each active load pull circuit is provided between (i) the multiplexer circuit 18 for combining the signal components into the composite signal and (ii) the DUT 10. Each active load pull circuit has three signal paths for the three component signals. Each side of the circuit applies load pull at the fundamental frequency and the first two harmonics. The topology of the load pull architecture is substantially the same on both sides of the circuit. The advantage of this architecture is the use of only a small number of passive tuners with the disadvantage that each passive tuner can influence the impedance of the entire frequency range, e.g. here at and around the fundamental, second and third harmonic frequency.

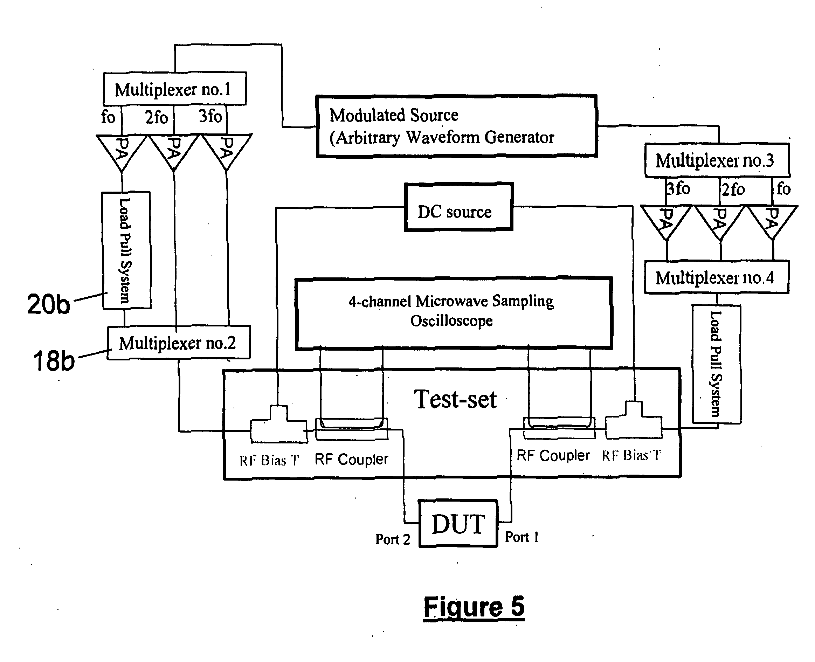

Figure 5 illustrates a third embodiment, in which the arrangement on the "Port 1" side is the same as shown in Figure 4, but the topology of the load pull architecture is different on the other ("port 2") side of the circuit. In this embodiment, the passive load pull device 20b on the "port 2" side of the circuit is provided in line with the signal path dedicated to the fundamental frequency signal component upstream (from the DUT 10) of the multiplexer 18b for combining the signal components into the composite signal, and downstream in this embodiment of the multiplexer 11b for dividing the composite signal from the waveform generator into separate component signals. The passive load pull device 20b is required only to modify the reflection coefficient at the fundamental frequency only, as the active load pull circuitry can generate the required power levels at the harmonic frequencies (where power requirements are lower).

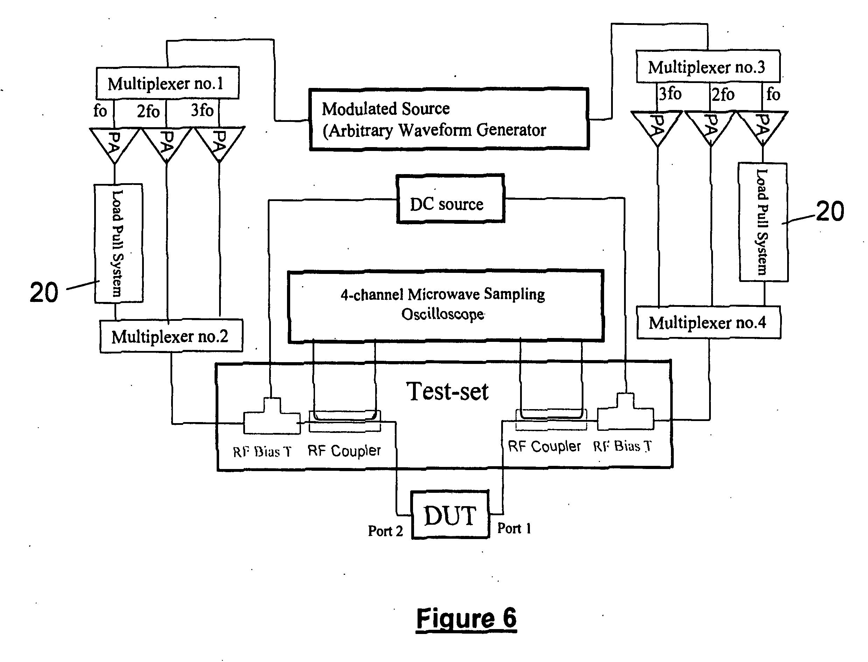

Figure 6 illustrates a fourth embodiment, in which the arrangement on the "Port 1" and "Port 2" sides are the same as the arrangement on the "Port 2" side of the third embodiment. Thus, in this circuit the passive load pull devices 20 act on the components of the signal applied at the DUT at or very close to the fundamental frequency only. Consequently, both passive tuners 20 introduce no impedances changes at the second and third harmonic frequency that can be detected at the DUT.

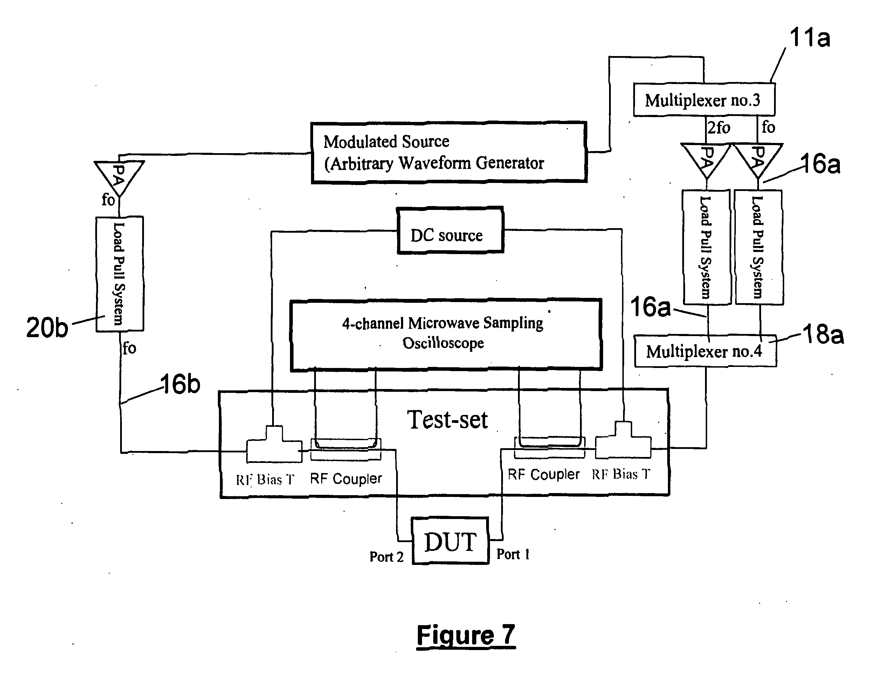

Figure 7 illustrates a fifth embodiment, with further different arrangements on both the "Port 1" and the "Port 2" sides. Thus, on the "Port 1" side, there are provided only two signal paths 16a between the multiplexers 11a, 18a, the signal paths being associated with the fundamental frequency $f_0$ and the first harmonic $2f_0$. On the "Port 2" side, there is provided only one signal path 16b, that path being associated with the fundamental frequency $f_0$ only. On the port 2 side, there is therefore only one passive load pull device 20b in line with the single signal path 16b and there is no need to provide multiplexers to split and then recombine signals. The impedance variations versus frequency that are introduced by the single passive tuner 20b connected to port 2 over the range of multiple harmonics can be compensated for by utilising broadband (multi-octave) power amplifier and modulated source or arbitrary waveform generator.

The hybrid systems of the embodiments described herein can be used in a variety of different applications. For example, the system can be used to characterise DUTs during manufacture of devices, or during design of circuits utilising high frequency high power non-linear devices. The hybrid system may for example be used for rapid screening or binning of measured components. Components may thus be efficiently binned into groups of components with similar characteristic. The embodiments of the invention facilitate switching to different load-pull requirements quickly, by using the active load pull circuits, without the need to invoke the slow mechanical changes of the passive tuners.

Whilst the present invention has been described and illustrated with reference to particular embodiments, it will be appreciated by those of ordinary skill in the art that the invention lends itself to many different variations not specifically illustrated herein. For example, other topologies of circuit may be utilized. The system may be used on DUTs have more than two ports. Multitone signals may be generated without the use of multiplexer circuits of the type illustrated.

**Claims**

1. Measurement apparatus for measuring the response of an electronic device (10) to a high frequency input signal, the measurement apparatus including:

    an active load-pull circuit (12a) connectable in use to an electronic device (10) to be measured, wherein
    the active load-pull circuit (12a) includes a passive load-pull device (20), **characterised in that** the passive load pull device (20) is configured to transform the characteristic inpedance of the load pull circuitry such that lower power levels are required to be generated by the active load pull circuit.

2. Measurement apparatus according to claim 1, wherein the active load-pull circuit (12a) is an open load-pull circuit.

3. Measurement apparatus according to claim 1, wherein the active load-pull circuit (12a) is an envelope load-pull circuit.

4. Measurement apparatus according to any preceding claim, wherein the active load-pull circuit (12a) includes a plurality of passive load-pull devices (20).

5. Measurement apparatus according to any preceding claim, wherein the measurement apparatus includes a signal generating circuit (14) arranged to generate a multi-component signal for applying to a device to be measured, the signal comprising components at a fundamental frequency and at one or more harmonic frequencies.

6. Measurement apparatus according to claim 5, wherein the measurement apparatus includes a plurality of signal paths (16), each signal path (16) being associated with a different component of the multi-component signal.

7. Measurement apparatus according to any preceding claim,
    wherein the apparatus is arranged to make measurements across a bandwidth of frequencies including a fundamental frequency and at least one harmonic frequency, and
    wherein the, or each, passive load-pull device (20) provided as part of the active load-pull circuit (12a) is arranged to function at all frequencies across the bandwidth.

8. Measurement apparatus according to any preceding claim, wherein the active load-pull circuit (12a) is arranged to compensate for the variation in impedance of the passive load pull device (20) at different frequencies.

9. Measurement apparatus according to any preceding claim, wherein the apparatus includes a plurality of active load-pull circuits (12a, 12b), each active load-pull circuit being connectable in use to a different port of a multi-port device, wherein
    each active load-pull circuit includes a passive load-pull device (20).

10. Measurement apparatus according to any preceding claim, wherein the topological arrangement of all of the one or more passive load pull devices (20) within one active load-pull circuit (12a) is different from the topological arrangement of all of the one or more passive load pull devices of another active load-pull circuit (12b).

11. A method of measuring the response of an electronic device under test to a high frequency input signal, the method including the following steps:

    providing a device under test (10) having one or more ports,
    providing a microwave frequency signal sampling apparatus measurement apparatus connected to take measurements from at least one of said ports,
    using an active load pull circuit (12a) to apply an active load at at least one of said ports, the active load including a signal having a low-frequency or DC component, a high-frequency component at a fundamental frequency, and a high-frequency component at a harmonic frequency, the active load being provided via one or more signal paths,
    providing a passive tuner component (20) in at least one of said one or more signal paths,
    simultaneously controlling the load applied to the device at the fundamental frequency and at a harmonic frequency, and **characterised by** setting the reflection coefficient at the fundamental frequency by using at least one such passive tuner component (20) to change the characteristic impedance of the active load circuit (12a) at the fundamental frequency, thus reducing the electric power of the signals required to be generated by the active load pull circuit (12a).

12. A method according to claim 11, wherein the method includes performing measurements in which the fundamental frequency is at a first frequency and then performing measurements in which the fundamental frequency is at a second frequency, different from the first frequency, using the same active load pull circuit (12a), the same passive tuner component (20) and the same device under test (10).

13. A method according to claim 12, including steps of setting said at least one such passive tuner component (20) in a first state in connection with measurements made with the fundamental frequency at the first frequency,

keeping said at least one such passive tuner component (20) set in said first state in connection with measurements made with the fundamental frequency at the second frequency, and

using the active load pull circuit (12a) to compensate for the change of the impedance of the passive tuner at the first frequency to the impedance of the passive tuner (20) at the second frequency.

14. A method of improving the design of a high frequency high power device or a circuit including a high frequency high power device, the method including the steps of analysing the behaviour of the device either by using the measurement apparatus of any of claims 1 to 10 or by performing the method of any of claims 11 to 13, and then modifying the design of the device or modifying the circuit including the device in consideration of the results of the analysing of the behaviour of the device.

15. A method of manufacturing a high frequency high power device or a circuit including a high frequency high power device, the method including the steps of improving the design of a similar existing device or of an existing circuit including such a device by performing the method of claim 14 and then manufacturing the device or the circuit including the device in accordance with the improved design.

**Patentansprüche**

1. Messvorrichtung zum Messen der Antwort einer elektronischen Vorrichtung (10) auf ein Hochfrequenz-Eingangssignal, wobei die Messvorrichtung umfasst:

eine aktive Load-Pull-Schaltung (12a), die im Gebrauch mit einer zu messenden elektronischen Vorrichtung (10) verbunden werden kann, wobei

die aktive Load-Pull-Schaltung (12a) eine passive Load-Pull-Vorrichtung (20) enthält,

**dadurch gekennzeichnet, dass** die passive Load-Pull-Vorrichtung (20) konfiguriert ist, die charakteristische Impedanz der Load-Pull-Schaltungsanordnung in der Weise zu transformieren, dass durch die aktive Load-Pull-Schaltung niedrigere Leistungspegel erzeugt werden müssen.

2. Messvorrichtung nach Anspruch 1, wobei die aktive Load-Pull-Schaltung (12a) eine offene Load-Pull-Schaltung ist.

3. Messvorrichtung nach Anspruch 1, wobei die aktive Load-Pull-Schaltung (12a) eine Hüllkurven-Load-Pull-Schaltung ist.

4. Messvorrichtung nach einem vorhergehenden Anspruch, wobei die aktive Load-Pull-Schaltung (12a) mehrere passive Load-Pull-Vorrichtungen (20) enthält.

5. Messvorrichtung nach einem vorhergehenden Anspruch, wobei die Messvorrichtung eine Signalerzeugungsschaltung (14) enthält, die dafür ausgelegt ist, ein Mehrkomponentensignal für die Eingabe in eine zu messende Vorrichtung zu erzeugen, wobei das Signal Komponenten bei einer Grundfrequenz und bei einer oder mehreren harmonischen Frequenzen enthält.

6. Messvorrichtung nach Anspruch 5, wobei die Messvorrichtung mehrere Signalwege (16) enthält, wobei jeder Signalweg (16) einer anderen Komponente des Mehrkomponentensignals zugeordnet ist.

7. Messvorrichtung nach einem vorhergehenden Anspruch,

wobei die Vorrichtung dafür ausgelegt ist, Messungen über eine Bandbreite von Frequenzen auszuführen, die eine Grundfrequenz und wenigstens eine harmonische Frequenz enthalten, und

wobei die oder jede passive Load-Pull-Vorrichtung (20), die als Teil der aktiven Load-Pull-Schaltung (12a) vorgesehen ist, dafür ausgelegt ist, bei allen Frequenzen über die Bandbreite zu arbeiten.

8. Messvorrichtung nach einem vorhergehenden Anspruch, wobei die aktive Load-Pull-Schaltung (12a) dafür ausgelegt ist, die Schwankung der Impedanz der passiven Load-Pull-Vorrichtung (20) bei unterschiedlichen Frequenzen auszugleichen.

9. Messvorrichtung nach einem vorhergehenden Anspruch, wobei die Vorrichtung mehrere aktive Load-Pull-Schaltungen (12a, 12b) enthält, wobei jede aktive Load-Pull-Schaltung im Gebrauch mit einem anderen Anschluss einer Mehranschlussvorrichtung verbunden werden kann, wobei
jede aktive Load-Pull-Schaltung eine passive Load-Pull-Vorrichtung (20) enthält.

10. Messvorrichtung nach einem vorhergehenden Anspruch, wobei sich die topologische Anordnung aller der einen oder der mehreren passiven Load-Pull-Vorrichtungen (20) in einer aktiven Load-Pull-Schaltung (12a) von der topologischen Anordnung aller der einen oder der mehreren passiven Load-Pull-Vorrichtungen einer weiteren aktiven Load-Pull-Schaltung (12b) unterschiedet.

11. Verfahren zum Messen der Antwort einer getesteten elektronischen Vorrichtung auf ein Hochfrequenz-Eingangssignal, wobei das Verfahren die folgenden Schritte umfasst:

Vorsehen einer zu testenden Vorrichtung (10), die einen oder mehrere Anschlüsse besitzt,
Vorsehen einer Vorrichtung zum Messen einer Mikrowellenfrequenzsignal-Abtastvorrichtung, die angeschlossen ist, um Messungen von wenigstens einem der Anschlüsse auszuführen,
Verwenden einer aktiven Load-Pull-Schaltung (12a), um auf wenigstens einen der Anschlüsse eine aktive Last anzuwenden, wobei die aktive Last ein Signal mit einer niederfrequenten oder Gleichstromkomponente, einer Hochfrequenzkomponente mit einer Grundfrequenz und einer Hochfrequenzkomponente mit einer harmonischen Frequenz enthält, wobei die aktive Last über einen oder mehrere Signalwege bereitgestellt wird,
Vorsehen einer passiven Abstimmkomponente (20) in wenigstens einem des einen oder der mehreren Signalwege,
gleichzeitiges Steuern der Last, die auf die Vorrichtung bei der Grundfrequenz und bei einer harmonischen Frequenz angewendet wird, **gekennzeichnet durch** das Einstellen des Reflexionskoeffizienten bei der Grundfrequenz unter Verwendung wenigstens einer solchen passiven Abstimmkomponente (20), um die charakteristische Impedanz der aktiven Lastschaltung (12a) bei der Grundfrequenz zu ändern, um so die elektrische Leistung der Signale, die von der aktiven Load-Pull-Schaltung (12a) erzeugt werden sollen, zu verringern.

12. Verfahren nach Anspruch 11, wobei das Verfahren das Ausführen von Messungen, bei denen die Grundfrequenz eine erste Frequenz ist, und dann das Ausführen von Messungen, bei denen die Grundfrequenz eine von der ersten Frequenz verschiedene zweite Frequenz ist, unter Verwendung derselben aktiven Load-Pull-Schaltung (12a), derselben passiven Abstimmkomponente (20) und derselben getesteten Vorrichtung (10) umfasst.

13. Verfahren nach Anspruch 12, das die folgenden Schritte umfasst:

Einstellen der wenigstens einen solchen passiven Abstimmkomponente (20) auf einen ersten Zustand in Verbindung mit Messungen, die mit der Grundfrequenz bei der ersten Frequenz ausgeführt werden,
Halten der wenigstens einen solchen passiven Abstimmkomponente (20), die auf den ersten Zustand eingestellt ist, in Verbindung mit Messungen, die mit der Grundfrequenz bei der zweiten Frequenz ausgeführt werden, und
Verwenden der aktiven Load-Pull-Schaltung (12a), um die Änderung der Impedanz der passiven Abstimmeinrichtung bei der ersten Frequenz zu der Impedanz der passiven Abstimmeinrichtung (20) bei der zweiten Frequenz auszugleichen.

14. Verfahren zum Verbessern des Entwurfs einer Hochfrequenz-Hochleistungs-Vorrichtung oder -Schaltung, die eine Hochfrequenz-Hochleistungs-Vorrichtung enthält, wobei das Verfahren die Schritte des Analysierens des Verhaltens der Vorrichtung entweder unter Verwendung der Messvorrichtung nach einem der Ansprüche 1 bis 10 oder durch Ausführen des Verfahrens nach einem der Ansprüche 11 bis 13 und dann des Modifizierens des Entwurfs der Vorrichtung oder des Modifizierens der Schaltung, die die Vorrichtung enthält, unter Berücksichtigung der Ergebnisse der Analyse des Verhaltens der Vorrichtung umfasst.

15. Verfahren zum Herstellen einer Hochfrequenz-Hochleistungs-Vorrichtung oder -Schaltung, die eine Hochfrequenz-Hochleistungs-Vorrichtung enthält, wobei das Verfahren die Schritte des Verbesserns des Entwurfs einer ähnlichen vorhandenen Vorrichtung oder einer vorhandenen Schaltung, die eine solche Vorrichtung enthält, durch Ausführen des Verfahrens nach Anspruch 14 und dann das Herstellen der Vorrichtung oder der Schaltung, die die Vorrichtung enthält, in Übereinstimmung mit dem verbesserten Entwurf umfasst.

**Revendications**

1. Appareil de mesure pour mesurer la réponse d'un dispositif électronique (10) à un signal d'entrée à haute fréquence, l'appareil de mesure incluant :

   un circuit d'extraction de charge active (12a) apte à être connecté, en utilisation, à un dispositif électronique (10) à mesurer, dans lequel le circuit d'extraction de charge active (12a) inclut un dispositif d'extraction de charge passive (20),
   **caractérisé en ce que** le dispositif d'extraction de charge passive (20) est configuré pour transformer l'impédance caractéristique des circuits d'extraction de charge de sorte que des niveaux de puissance inférieurs doivent être générés par le circuit d'extraction de charge active.

2. Appareil de mesure selon la revendication 1, dans lequel le circuit d'extraction de charge active (12a) est un circuit d'extraction de charge ouvert.

3. Appareil de mesure selon la revendication 1, dans lequel le circuit d'extraction de charge active (12a) est un circuit d'extraction de charge à enveloppe.

4. Appareil de mesure selon l'une quelconque des revendications précédentes, dans lequel le circuit d'extraction de charge active (12a) inclut une pluralité de dispositifs d'extraction de charge passive (20).

5. Appareil de mesure selon l'une quelconque des revendications précédentes, dans lequel l'appareil de mesure inclut un circuit de génération de signal (14) configuré pour générer un signal à composantes multiples pour une application à un dispositif devant être mesuré, le signal comprenant des composantes à une fréquence fondamentale et à une ou plusieurs fréquences harmoniques.

6. Appareil de mesure selon la revendication 5, dans lequel l'appareil de mesure inclut une pluralité de chemins de signaux (16), chaque chemin de signal (16) étant associé à une composante différente du signal à composantes multiples.

7. Appareil de mesure selon l'une quelconque des revendications précédentes,
   dans lequel l'appareil est configuré pour réaliser des mesures à travers une largeur de bande de fréquences incluant une fréquence fondamentale et au moins une fréquence harmonique, et
   dans lequel le, ou chaque, dispositif d'extraction de charge passive (20) en tant que partie du circuit d'extraction de charge active (12a) est configuré pour fonctionner à toutes les fréquences à travers la largeur de bande.

8. Appareil de mesure selon l'une quelconque des revendications précédentes, dans lequel le circuit d'extraction de charge active (12a) est configuré pour compenser la variation d'impédance du dispositif d'extraction de charge passive (20) à différentes fréquences.

9. Appareil de mesure selon l'une quelconque des revendications précédentes, dans lequel l'appareil inclut une pluralité de circuits d'extraction de charge active (12a, 12b), chaque circuit d'extraction de charge active étant apte à être connecté, en utilisation, à un port différent d'un dispositif à ports multiples, dans lequel
   chaque circuit d'extraction de charge active inclut un dispositif d'extraction de charge passive (20).

10. Appareil de mesure selon l'une quelconque des revendications précédentes, dans lequel l'agencement topologique de la totalité du ou des dispositifs d'extraction de charge passive (20) à l'intérieur d'un circuit d'extraction de charge active (12a) est différent de l'agencement topologique de la totalité du ou des dispositifs d'extraction de charge passive d'un autre circuit d'extraction de charge active (12b).

11. Procédé de mesure de la réponse d'un dispositif électronique en essai à un signal d'entrée à haute fréquence, le procédé incluant les étapes suivantes :

    fournir un dispositif en essai (10) ayant un ou plusieurs ports,
    fournir un appareil de mesure d'appareil d'échantillonnage de signal hyperfréquence connecté pour réaliser des mesures à partir d'au moins l'un desdits ports,
    utiliser un circuit d'extraction de charge active (12a) pour appliquer une charge active à au moins l'un desdits ports, la charge active incluant un signal ayant une composante basse fréquence ou continue, une composante haute fréquence à une fréquence fondamentale, et une composante haute fréquence à une fréquence harmonique, la charge active étant fournie via un ou plusieurs chemins de signal,
    fournir un composant de syntoniseur passif (20) dans au moins l'un desdits un ou plusieurs chemins de signal,
    commander simultanément la charge appliquée au dispositif à la fréquence fondamentale et à une fréquence harmonique, et **caractérisé par** le réglage du coefficient de réflexion à la fréquence fondamentale en utilisant au moins un tel composant de syntoniseur passif (20) pour changer l'impédance caractéristique du circuit de charge active (12a) à la fréquence fondamentale, en réduisant ainsi la puissance électrique des signaux devant être générés par le circuit d'extraction de charge active (12a).

**12.** Procédé selon la revendication 11, dans lequel le procédé inclut la réalisation de mesures dans lesquelles la fréquence fondamentale est à une première fréquence et ensuite la réalisation de mesures dans lesquelles la fréquence fondamentale est à une seconde fréquence, différente de la première fréquence, en utilisant le même circuit d'extraction de charge active (12a), le même composant de syntoniseur passif (20) et le même dispositif en essai (10).

**13.** Procédé selon la revendication 12, incluant les étapes de :

régler ledit au moins un composant de syntoniseur passif (20) dans un premier état en liaison avec des mesures réalisées avec la fréquence fondamentale à la première fréquence,
maintenir ledit au moins un tel composant de syntoniseur passif (20) réglé dans ledit premier état en liaison avec des mesures réalisées avec la fréquence fondamentale à la seconde fréquence, et
utiliser le circuit d'extraction de charge active (12a) pour compenser le changement de l'impédance du syntoniseur passif à la première fréquence, en l'impédance du syntoniseur passif (20) à la seconde fréquence.

**14.** Procédé d'amélioration de la conception d'un dispositif à haute puissance et à haute fréquence ou d'un circuit incluant un dispositif à haute puissance et à haute fréquence, le procédé incluant les étapes d'analyse du comportement du dispositif soit en utilisant l'appareil de mesure de l'une quelconque des revendications 1 à 10, soit en mettant en oeuvre le procédé de l'une quelconque des revendications 11 à 13, et en modifiant ensuite la conception du dispositif ou en modifiant le circuit incluant le dispositif en tenant compte des résultats de l'analyse du comportement du dispositif.

**15.** Procédé de fabrication d'un dispositif à haute puissance et à haute fréquence ou d'un circuit incluant un dispositif à haute puissance et à haute fréquence, le procédé incluant les étapes d'amélioration de la conception d'un dispositif similaire existant ou d'un circuit existant incluant un tel dispositif en mettant en oeuvre le procédé de la revendication 14 et en fabriquant ensuite le dispositif ou le circuit incluant le dispositif conformément à la conception améliorée.

Figure 1

**Figure 2**

Figure 3

**Figure 4**

EP 2 438 451 B1

**Figure 5**

**Figure 6**

EP 2 438 451 B1

**Figure 7**

EP 2 438 451 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2005010538 A